# EUROPÄISCHE PATENTSCHRIFT

(11) **EP 1 748 299 B1**
(45) Veröffentlichungstag und Bekanntmachung des Hinweises auf die Patenterteilung: **19.03.2008**
(21) Anmeldenummer: 05016557.0
(22) Anmeldetag: 29.07.2005
(51) Int. Cl.: G01R 31/317

(54) **Elektronische Schaltung, System mit einer elektronischen Schaltung und Verfahren zum Testen einer elektronischen Schaltung**
Electronic circuit, system with an electronic circuit and method to test an electronic circuit
Circuit électronique, système avec un circuit électronique et procédé pour tester un circuit électronique

(43) Veröffentlichungstag der Anmeldung: 31.01.2007
(73) Patentinhaber: SIEMENS AKTIENGESELLSCHAFT, 80333 München (DE)
(72) Erfinder: Barthel, Herbert, 91074 Herzogenaurach (DE); Binder, Ingmar, 92289 Ursensollen (DE)

(56) Entgegenhaltungen:
- US-A1- 2004 267 479
- US-B1- 6 477 674
- US-B1- 6 867 613

## Beschreibung

Die Erfindung betrifft eine elektronische Schaltung mit mindestens einem Eingang und mindestens einem Ausgang, wobei der Eingang ein Eingangsfilter zur Verzögerung einer Änderung eines Eingangssignal aufweist, wobei die Verzögerung durch eine Zeitkonstante charakterisiert ist und wobei eine Ansteuerkomponente zur Bereitstellung eines Ausgangssignals und zur Auswertung des Eingangssignals vorgesehen ist. Die Erfindung betrifft zudem ein System mit einer solchen elektronischen Schaltung und mindestens einer sicherheitsgerichteten Komponente, welche an mindestens einen Eingang und mindestens einen Ausgang der Schaltung angeschlossen ist sowie ein Verfahren zum Testen einer elektronischen Schaltung.

Insbesondere in sicherheitsgerichteten Anlagen müssen Fehler aller Art mit hoher Wahrscheinlichkeit erkannt werden und so beherrscht werden, dass sie keine unzulässige Reaktion auslösen. Dies gilt insbesondere auch für Sensoren und für elektronische Schaltungen, welche die Signale der Sensoren als Eingangssignal aufnehmen. Eine solche elektronische Schaltung ist beispielsweise eine digitale Eingabebaugruppe. Ein Hindernis für die Anwendung von Standard-Ein-/Ausgabebaugruppen für die Sicherheitstechnik ist häufig ein gemeinsamer Ein-/ Ausgabe-Treiberbaustein. Insbesondere bestimmte interne Kurzschlüsse in diesem Treiberbaustein können durch herkömmliche Tests nicht aufgedeckt werden. Dazu müsste der jeweilige Eingang auch von außen getestet werden. Für Anwendungen in der Sicherheitstechnik müssen aber alle Kurzschlüsse und Unterbrechungen aufgedeckt werden, insbesondere auch baugruppeninterne Kurzschlüsse. In der Prozess- und Fertigungstechnik gibt es für vielfältige Anwendungen Module, die zusätzlich zu Eingängen auch Ausgänge aufweisen. Solche Module sind z. B. die üblicherweise eingesetzten Bedienpanels. Die Eingänge und Ausgänge sind häufig als Digitaleingänge bzw. Digitalausgänge ausgeführt. Über Digitaleingänge können beispielsweise Schlüsselschalter und über Digitalausgänge können Signallampen angeschlossen sein. Typischerweise ist eine relativ große Anzahl von solchen Eingängen und Ausgängen vorhanden, von denen jedoch oft nur ein Teil benutzt wird. Die Nutzung von zumindest einem Teil der Ein-/Ausgänge von Standardschaltungen für sicherheitsgerichtete Aufgaben scheitert üblicherweise daran, dass mit der Standardhardware die Sicherheitsanforderungen nicht erfüllt werden können.

Aus der US 6 477 674 ist eine integrierte Schaltung, die Test Signale generiert und diese mittels einer Rückführung auswertet. Hierbei werden Verzögerungselemente verwendet.

Der Erfindung liegt die Aufgabe zugrunde, die Fehlererkennungswahrscheinlichkeit bei einer elektronischen Schaltung mit mindestens einem Eingang und mindestens einem Ausgang zu erhöhen.

Diese Aufgabe wird durch eine elektronische Schaltung mit mindestens einem Eingang und mindestens einem Ausgang gelöst, wobei der Eingang ein Eingangsfilter zur Verzögerung einer Änderung eines Eingangssignals aufweist, wobei die Verzögerung durch eine Zeitkonstante charakterisiert ist, wobei eine Ansteuerkomponente zur Bereitstellung eines Ausgangssignals und zur Auswertung des Eingangssignals vorgesehen ist, wobei die Ansteuerkomponente zur Bereitstellung eines Testsignals zur Ausgabe durch den Ausgang und zu einer ersten Auswertung des Eingangssignals unmittelbar nach Ausgabe des Testsignals und zu einer zweiten Auswertung des Eingangssignals nach Ablauf einer Zeit nach Ausgabe des Testsignals, die mindestens der Zeitkonstanten entspricht, vorgesehen ist.

Diese Aufgabe wird durch ein System, insbesondere ein industrielles Automatisierungssystem, mit einer solchen Schaltung gelöst, wobei das System mindestens eine sicherheitsgerichtete Komponente aufweist, welche an mindestens einen Eingang und mindestens einen Ausgang der Schaltung derart angeschlossen ist, dass der jeweilige Eingang mit dem jeweiligen Ausgang im sicheren Zustand elektrisch leitend verbunden ist.

Diese Aufgabe wird durch ein Verfahren zum Testen einer elektronischen Schaltung gelöst, wobei die elektronische Schaltung mindestens einen Eingang und mindestens einen Ausgang aufweist, bei welchem Verfahren eine Änderung eines Eingangssignals durch ein Eingangsfilter des Eingangs verzögert wird, wobei die Verzögerung durch eine Zeitkonstante charakterisiert ist, wobei das Eingangssignal durch eine Ansteuerkomponente bereitgestellt und ausgewertet wird, wobei ein durch die Ansteuerkomponente bereitgestelltes Testsignal durch den Ausgang ausgegeben wird und das Eingangssignal unmittelbar nach Ausgabe des Testsignals zum ersten Mal und nach Ablauf einer Zeit nach Ausgabe des Testsignals, die mindestens der Zeitkonstanten entspricht, zum zweiten Mal ausgewertet wird.

Die erfindungsgemäße Lösung nutzt in geschickter Weise aus, dass üblicherweise Eingänge einer elektronischen Schaltung mit Eingangsfiltern zur Verzögerung einer Änderung eines Eingangssignals, insbesondere zur Störfilterung, versehen sind. Die elektronische Schaltung kann auf interne Kurzschlüsse, Querschlüsse und Unterbrechungen getestet werden, indem zuerst unmittelbar nach Ausgabe eines Ausgangssignals der Wert am Eingang geprüft wird und anschließend nach Ablauf der Filterzeitkonstanten nochmals. Bedingt durch die verzögernde Funktion des Eingangsfilters darf sich im fehlerfreien Fall der Wert des Eingangssignals beim erstmaligen, d. h. beim sofortigen Lesen bzw. Auswerten nicht ändern. Der Wert des Eingangssignals darf sich erst mit Ablauf der Filterzeitkonstanten des Eingangsfilters ändern. Wenn er sich bereits vorher ändert, zeigt dies, dass ein Hardwarefehler vorliegt, insbesondere ein Kurzschluss oder ein Querschluss innerhalb der elektronischen Schaltung.

Gemäß einer vorteilhaften Ausgestaltung der Erfindung ist die Ansteuerkomponente zur ersten Auswertung des Eingangssignals innerhalb einer Zeit nach Ausgabe des Testsignals vorgesehen, die maximal 10 Prozent der Zeitkonstanten beträgt. Damit wird sichergestellt, dass die erste Auswertung des Eingangssignals tatsächlich unmittelbar nach Ausgabe des Testsignals erfolgt und somit noch keine Änderung des Eingangssignals nach dem Eingangsfilter durch eine Änderung des Eingangssignals vor dem Eingangsfilter verursacht sein kann. Sowohl die erste als auch die zweite Auswertung des Eingangssignals erfolgt grundsätzlich nach dem Eingangsfilter, d. h. nach Durchlauf des Eingangssignals durch das Eingangsfilter. Das Eingangssignal wird von der Ansteuerkomponente also erst nach dem Eingangsfilter erfasst und ausgewertet, entweder direkt danach oder aber nach weiteren zwischengeschalteten Komponenten, z. B. einem Treiberbaustein.

Weitere Hinweise auf Fehler in der elektronischen Schaltung lassen sich ermitteln, wenn gemäß einer vorteilhaften Ausgestaltung der Erfindung die Ansteuerkomponente zum Vergleich jeweils der ersten und der zweiten Auswertung mit dem Testsignal vorgesehen ist.

Vorteilhafterweise wird durch die Ansteuerkomponente eine sicherheitsgerichtete Reaktion ausgelöst, sofern die erste Auswertung ein Eingangssignal gleich dem Testsignal ergibt. Da zum Zeitpunkt der ersten Auswertung das Eingangssignal ungleich dem Testsignal sein müsste, deutet eine Übereinstimmung auf einen Fehler innerhalb der elektronischen Schaltung hin, welcher durch die sicherheitsgerichtete Reaktion beherrscht wird. Eine sicherheitsgerichtete Reaktion bringt die elektronischen Schaltung und ein mit der Schaltung verbundenes System in einen sicheren Zustand, häufig erreicht durch sofortiges Abschalten aller oder zumindest einem Teil der Aktoren in dem System.

Gemäß einer weiteren vorteilhaften Ausgestaltung der Erfindung ist mindestens ein Treiberbaustein zur Umsetzung der Ein- und Ausgangssignale vorgesehen, wobei der Treiberbaustein zwischen der Ansteuerkomponente und dem Eingang bzw. dem Ausgang angeordnet ist. Der Treiberbaustein ermöglicht insbesondere eine Spannungs- oder Stromumsetzung und/oder eine Verstärkung der Ein- und Ausgangssignale.

Eine besonders einfache Auswertung der Eingangssignale ergibt sich, wenn gemäß einer weiteren vorteilhaften Ausgestaltung der mindestens eine Eingang ein digitaler Eingang und der mindestens eine Ausgang ein digitaler Ausgang ist. In diesem Fall wird das Testsignal als Signalwechsel von Null zu Eins oder umgekehrt ausgeführt.

Um erhöhte Sicherheitsanforderungen zu erfüllen, insbesondere zur Erreichung einer Sicherheitsklasse größer SIL 2 (SIL = Safety Integrity Level, gemäß IEC 61508), wird gemäß einer weiteren vorteilhaften Ausgestaltung der Erfindung vorgeschlagen, dass jeweils mindestens zwei Eingänge und zwei Ausgänge vorgesehen sind. Die Sicherheit wird so durch die redundante Erfassung des an den jeweiligen Ein-/Ausgängen anliegenden Sensorsignals erhöht.

Gemäß einer weiteren vorteilhaften Ausgestaltung der Erfindung weist die Ansteuerkomponente sicherheitsgerichtete Firmware-Komponenten auf. Diese sicherheitsgerichteten Firmware-Komponenten sind insbesondere zur Ausführung der Bereitstellung des Ausgangssignals und zur Auswertung des Eingangssignals geeignet. Damit lassen sich auch elektronische Standardschaltungen, welcher keine sicherheitsgerichteten Hardwareeigenschaften aufweisen, mittels einer Ergänzung der Firmware der Ansteuerkomponente für sicherheitsgerichtete Aufgaben ertüchtigen.

Gemäß einer weiteren vorteilhaften Ausgestaltung der Erfindung ist die Schaltung für den Einsatz innerhalb eines sicherheitsgerichteten Systems dadurch besonders geeignet, dass mindestens eine sicherheitsgerichtete Komponente an mindestens einen Eingang und mindestens einen Ausgang derart anschließbar ist, dass der jeweilige Eingang mit dem jeweiligen Ausgang im sicheren Zustand elektrisch leitend verbunden ist. Der sichere Zustand ist beispielsweise der Zustand, in dem eine sicherheitsgerichtete Komponente, z. B. ein Notaus-Taster, nicht betätigt ist, das bedeutet, dass die leitende Verbindung hergestellt ist.

Nachfolgend wird die Erfindung anhand des in den Figuren dargestellten Ausführungsbeispiels näher beschrieben und erläutert.

Es zeigen:
- FIG 1: eine elektronische Schaltung in einem Automatisierungssystem und
- FIG 2: die Zeitverläufe der Eingangs- und Ausgangssignale, insbesondere während eines Testzyklus.

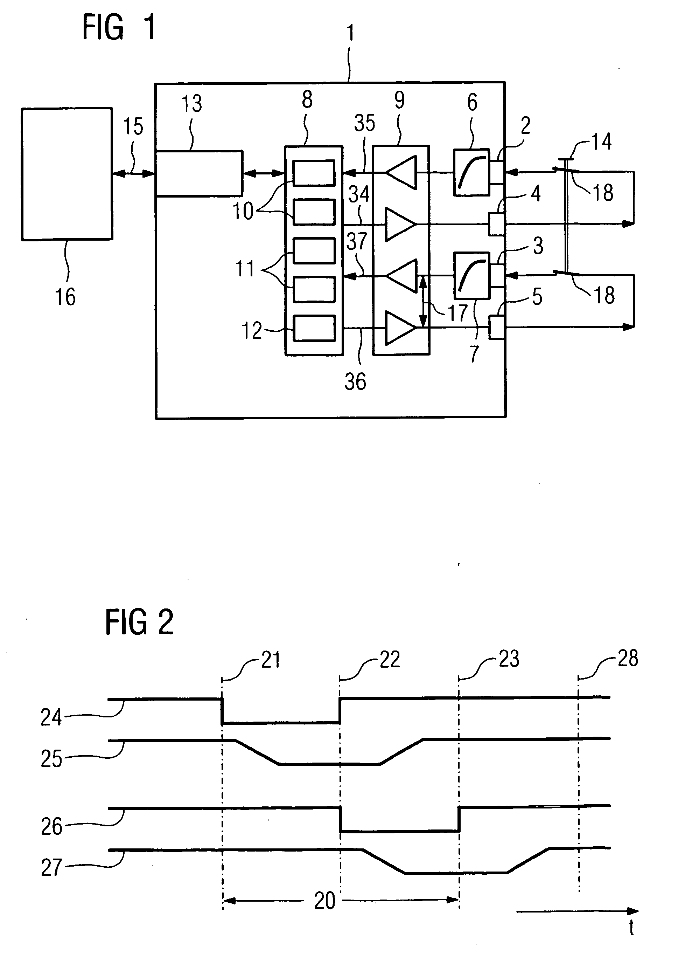

FIG 1 zeigt eine elektronische Schaltung 1 mit zwei Eingängen 2, 3 und zwei Ausgängen 4, 5. Die Eingänge 2, 3, gemäß Ausführungsbeispiel digitale Eingänge, weisen jeweils ein Eingangsfilter 6 bzw. 7 zur Verzögerung einer Änderung eines Eingangssignals auf. Ein solches Eingangsfilter ist typischerweise ein Verzögerungsglied 1. Ordnung, z. B. ein RC-Filter. Eine Ansteuerkomponente 8 dient zur Bereitstellung von Ausgangssignalen sowie zur Auswertung der Eingangssignale. Die Ansteuerkomponente 8 weist sowohl nicht sicherheitsgerichtete Firmware-Komponenten 10 als auch sicherheitsgerichtete Firmware-Komponenten 11, 12 auf. Die Ansteuerkomponente 8 kommuniziert bidirektional mit einem Schnittstellenelement 13, welches als Schnittstelle zu einem Kommunikationsnetz 15 dient, welches mit weiteren Komponenten 16 eines industriellen Automatisierungssystems verbunden ist. Solch eine weitere Komponente 16 kann insbesondere eine speicherprogrammierbare Steuerung sein. Die elektronische Schaltung 1 ist ein Teil des industriellen Automatisierungssystems. Die elektronische Schaltung 1, gemäß Ausführungsbeispiel eine Peripheriebaugruppe eines Automatisierungssystems, ist über die Eingänge 2, 3 und die Ausgänge 4, 5 mit einer sicherheitsgerichteten Komponente 14, im dargestellten Fall mit einem Notaus-Taster, verbunden. Eine solche sicherheitsgerichtete Komponente 14 kann z. B. auch eine Trittmatte, ein Lichtgitter, eine Türverriegelung und ähnliches sein. Dabei ist jeweils ein Schaltkontakt 18 mit einem Eingang und einem diesem zugeordneten Ausgang verbunden. Üblicherweise ist die sicherheitsgerichtete Komponente 14 so verschaltet, dass die Schaltkontakte 18 bei Betätigung der sicherheitsgerichteten Komponente 14, in diesem Fall bei Betätigung des Notaus-Tasters 14, geöffnet werden. Eine solche Schaltung des Schaltkontakts 18 zwischen einen Ausgang und einen Eingang einer Peripherieschaltung ist in sicherheitsgerichteten Systemen üblich. Der externe Sensor, also die sicherheitsgerichtete Komponente 14, in diesem Fall der Notaus-Taster, wird somit durch den Ausgang 4, 5 der elektronischen Schaltung 1 versorgt. Zur Erhöhung der Sicherheit werden beide Kontakte 18 von der elektronischen Schaltung 1 angesteuert bzw. überwacht. Prinzipiell kann das erfindungsgemäße Verfahren jedoch auch mit einer elektronischen Schaltung mit nur einem Ausgang und einem Eingang ausgeführt werden. In diesem Fall wäre der im Folgenden beschriebene Testzyklus 20 nur halb so lang und würde bereits zum Zeitpunkt 22 enden. Insbesondere bei Sicherheitsanforderungen bis SIL 2 reicht nur ein Eingang und ein Ausgang.

Typischerweise ist bei Baugruppen jedoch sowieso eine relativ große Anzahl von solchen Eingängen 2, 3 und Ausgängen 4, 5 vorhanden, von denen oft nur ein Teil benutzt wird. Die Erfindung ermöglicht nun die Nutzung von zumindest einem Teil der Ein-/Ausgänge 2 bis 5 von Standardschaltungen für sicherheitsgerichtete Aufgaben, z. B. zum Betreiben eines Notaus-Tasters. Bisherige Lösungen setzen hierfür eine Spezial-Hardware ein, die explizit für Sicherheitsanwendungen entwickelt und ausgeführt wurde. Diese üblichen Lösungen arbeiten mit getrennten Ein-/Ausgangs-Treiberbausteinen und werden mit spezieller Ein-/Ausgangsbeschaltung versehen.

Der Treiberbaustein 9 dient zur Umsetzung der Eingangssignale bzw. der Ausgangssignale, insbesondere zur Spannungsumsetzung und zur Verstärkung dieser Signale. Mit dem Bezugszeichen 17 ist ein interner Kurzschluss im Treiberbaustein 9 bezeichnet. Mit den Bezugszeichen 34 bis 37 werden die von der Ansteuerkomponente 8 ausgegebenen bzw. erfassten und ausgewerteten Ausgangs- bzw. Eingangssignale bezeichnet.

FIG 2 zeigt den zeitlichen Verlauf dieser an den Punkten 34 bis 37 gemäß FIG 1 erfassten bzw. ausgegebenen Signale, insbesondere während eines Testzyklus 20. Der zeitliche Fortgang ist mit dem Bezugszeichen t gekennzeichnet. Die Kurve 24 zeigt den zeitlichen Verlauf des Ausgangssignals am Punkt 34, die Kurve 25 den zeitlichen Verlauf des Eingangssignals am Punkt 35, die Kurve 26 den zeitlichen Verlauf des Ausgangssignals am Punkt 36 und die Kurve 27 den zeitlichen Verlauf des Eingangssignals am Punkt 37. Das Ausgangssignal 24 und das Ausgangssignal 26 entsprechen innerhalb des Testzyklus 20 jeweils einem Testsignal. Mit den Bezugszeichen 21, 22 und 23 sind drei Zeitpunkte gekennzeichnet, welche den Testzyklus 20 kennzeichnen und zu welchen entweder das Ausgangssignal 24 oder das Ausgangssignal 26 seinen Wert ändert. Gemäß dem in FIG 1 und FIG 2 dargestellten Ausführungsbeispiel beträgt die Zeitkonstante der Eingangsfilter 6 und 7 jeweils 20 ms. Dementsprechend dauert der Testzyklus 20 vorteilhafterweise 40 ms, wobei für 20 ms das Ausgangssignal 24 auf Null gesetzt wird und für die darauf folgenden 20 ms das Ausgangssignal 26 auf Null gesetzt wird. Solchermaßen gewählte Werte für die Zeitkonstante der Eingangsfilter 6, 7 bzw. für die Länge des Testzyklus 20 sind typische Werte in einem Fall, bei welchem eine maximale Reaktionszeit auf eine Betätigung des Notaus-Tasters von 100 ms gefordert wird. In diesem Fall würde der Testzyklus 20 alle 100 ms gestartet. In der innerhalb dieser 100 ms nicht durch den Testzyklus 20 belegten Zeit würde eine Betätigung des Notaus-Tasters, d. h. ein Öffnen der Schaltkontakte 18, mit der erforderlichen Reaktionszeit, also innerhalb von maximal 100 ms, erfasst werden.

Im Folgenden wird anhand von FIG 1 und FIG 2 ein Ausführungsbeispiel des erfindungsgemäßen Verfahrens näher erläutert. Unmittelbar vor dem Zeitpunkt 21 werden die Eingangssignale 25 und 27 am Punkt 35 bzw. 37 der elektronischen Schaltung 1 durch die Ansteuerkomponente 8 erfasst und ausgewertet. Wenn eines der beiden Eingangssignale auf Null ist, wird ein interner Merker, der in der Ansteuerkomponente 8 verarbeitet und gespeichert wird, ebenfalls auf Null gesetzt, da dies auf einen Fehler oder einen gedrückten Notaus-Taster hinweist. Wenn das nicht der Fall ist, wird der interne Merker auf Eins vorbesetzt. Zum Zeitpunkt 21, d. h. zu Beginn des Testzyklus 20 wird das Ausgangssignal 24 durch die Ansteuerkomponente 8 von Eins auf Null gesetzt. Unmittelbar danach wird das Eingangssignal 25 am Punkt 35, d. h. nach dem Eingangsfilter 6, abgefragt, d. h. durch die Ansteuerkomponente 8 erfasst und ausgewertet. Es wird durch die Ansteuerkomponente 8 ausgewertet, und wenn das Eingangssignal 25 zu diesem Zeitpunkt Null ist, wird der interne Merker auf den Wert Null gesetzt, was auf einen möglichen Hardware-Fehler, insbesondere einen internen Kurzschluss im Treiberbaustein 9, hindeutet. Unmittelbar vor dem Zeitpunkt 22, d. h. ungefähr zur Mitte des Testzyklus 20, wird durch die Ansteuerkomponente 8 das Eingangssignal 27 am Punkt 37 abgefragt und ausgewertet. Wenn das Eingangssignal 27 zu diesem Zeitpunkt Null ist, wird der interne Merker auf Null gesetzt. Ebenso wird zu diesem Zeitpunkt das Eingangssignal 25 am Punkt 35 abgefragt und ausgewertet. Wenn das Eingangssignal 25 zu diesem Zeitpunkt den Wert Eins aufweist, dann wird der Merker auf Null gesetzt, was in diesem Fall auf einen internen oder externen Fehler (z. B. Kurzschluss gegen Eins) hindeutet. Zum Zeitpunkt 22 wird das Ausgangssignal 24 wieder auf Eins gesetzt und das Ausgangssignal 26 auf Null gesetzt. Unmittelbar danach wird durch die Ansteuerkomponente 8 das Eingangssignal 27 am Punkt 37 abgefragt und ausgewertet. Wenn das Eingangssignal 27 zu diesem Zeitpunkt den Wert Null aufweist, wird der interne Merker auf Null gesetzt, d. h. ein möglicher Hardware-Fehler, z. B. intern auf der elektronischen Schaltung, wird detektiert, insbesondere ein interner Kurzschluss 17 im Treiberbaustein 9. Schließlich wird unmittelbar vor dem Zeitpunkt 23 das Eingangssignal 25 am Punkt 35 abgefragt und ausgewertet. Ist das Eingangssignal 25 zu diesem Zeitpunkt Null, dann wird der interne Merker auf Null gesetzt. Ebenso wird das Eingangssignal 27 am Punkt 37 abgefragt und ausgewertet. Ist das Eingangssignal 27 zu diesem Zeitpunkt Eins, dann wird der interne Merker auf Null gesetzt, was auf einen internen oder externen Fehler (z. B. Kurzschluss gegen Eins) hindeutet. Schließlich wird zum Zeitpunkt 23, d.h. am Ende des Testzyklus 20, das Ausgangssignal 26 wieder auf den Wert Eins gesetzt. Wenn das Eingangssignal 27 seinen Ursprungswert erreicht hat bzw. der Zeitpunkt 2B erreicht ist, dann steht die elektronische Schaltung 1 wieder dem bestimmungsgemäßen Gebrauch, d. h. hier der Abfrage des Notaus-Tasters zur Verfügung.

Gemäß dem Ausführungsbeispiel der Erfindung wird der Treiberbaustein 9 somit auf interne Kurzschlüsse, Querschlüsse und Unterbrechungen getestet, indem zuerst unmittelbar (üblicherweise wenige Mikrosekunden) nach Ansteuerung/Befehl "Wechsel des Testsignals" der Wert am Eingang geprüft wird und anschließend nach Ablauf der Filterzeitkonstanten nochmals. Bedingt durch die Funktion des Eingangsfilters darf sich der Eingangswert nach dem Filter beim sofortigen Lesen nicht ändern. Er darf sich erst mit Ablauf der Filterzeit des Eingangsfilters ändern. Wenn er sich bereits vorher ändert zeigt dies, dass ein Hardware-Fehler vorliegt (z. B. Kurzschluss 17 oder Querschluss auf dem Treiberbaustein 9) und automatisch sicherheitsgerichtet reagiert werden muss (z. B. Sicherheits-Eingangsdaten auf Null und Fehlermeldung).

Zusammengefasst betrifft die Erfindung somit eine elektronische Schaltung 1 mit mindestens einem Eingang 2, 3 und mindestens einem Ausgang 4, 5, wobei der Eingang 2, 3 ein Eingangsfilter 6, 7 zur Verzögerung einer Änderung eines Eingangssignal aufweist, wobei die Verzögerung durch eine Zeitkonstante charakterisiert ist und wobei eine Ansteuerkomponente 8 zur Bereitstellung eines Ausgangssignals und zur Auswertung des Eingangssignals vorgesehen ist. Die Erfindung betrifft zudem ein System mit einer solchen elektronischen Schaltung 1 und mindestens einer sicherheitsgerichteten Komponente 14, 18, welche an mindestens einen Eingang 2, 3 und mindestens einen Ausgang 4, 5 der Schaltung 1 angeschlossen ist sowie ein Verfahren zum Testen einer elektronischen Schaltung 1. Um die Fehlererkennungswahrscheinlichkeit bei einer solchen elektronischen Schaltung 1 zu erhöhen, wird vorgeschlagen, dass die Ansteuerkomponente 8 zur Bereitstellung eines Testsignals zur Ausgabe durch den Ausgang 4, 5 und zu einer ersten Auswertung des Eingangssignals unmittelbar nach Ausgabe des Testsignals und zu einer zweiten Auswertung des Eingangssignals nach Ablauf einer Zeit nach Ausgabe des Testsignals, die mindestens der Zeitkonstanten entspricht, vorgesehen ist.

## Patentansprüche

1. Elektronische Schaltung (1) mit mindestens einem Eingang (2, 3) und mindestens einem Ausgang (4, 5), wobei der Eingang (2, 3) ein Eingangsfilter (6, 7) zur Verzögerung einer Änderung eines Eingangssignals aufweist, wobei die Verzögerung durch eine Zeitkonstante charakterisiert ist, wobei die elektronische Schaltung eine Ansteuerkomponente (8) zur Bereitstellung eines Ausgangssignals und zur Auswertung des Eingangssignals aufweist, wobei das Ausgangssignal zur Rückführung auf den Eingang vorgesehen ist,
**dadurch gekennzeichnet,**
**dass** die Ansteuerkomponente (8) zur Bereitstellung eines Testsignals zur Ausgabe durch den Ausgang (4, 5) und zu einer ersten Auswertung des Eingangssignals unmittelbar nach Ausgabe des Testsignals und zu einer zweiten Auswertung des Eingangssignals nach Ablauf einer Zeit nach Ausgabe des Testsignals, die mindestens der Zeitkonstanten entspricht, vorgesehen ist.

2. Schaltung nach Anspruch 1,
**dadurch gekennzeichnet,**
**dass** die Ansteuerkomponente (8) zur ersten Auswertung des Eingangssignals innerhalb einer Zeit nach Ausgabe des Testsignals vorgesehen ist, die maximal 10 Prozent der Zeitkonstanten beträgt.

3. Schaltung nach Anspruch 1 oder 2,
**dadurch gekennzeichnet,**
**dass** die Ansteuerkomponente (8) zum Vergleich jeweils der ersten und der zweiten Auswertung mit dem Testsignal vorgesehen ist.

4. Schaltung nach einem der vorhergehenden Ansprüche,
**dadurch gekennzeichnet,**
**dass** die Ansteuerkomponente (8) zum Auslösen einer sicherheitsgerichteten Reaktion vorgesehen ist, sofern die erste Auswertung ein Eingangssignal gleich dem Testsignal ergibt.

5. Schaltung nach einem der vorhergehenden Ansprüche,
**dadurch gekennzeichnet,**
**dass** mindestens ein Treiberbaustein (9) zur Umsetzung der Ein- und Ausgangssignale vorgesehen ist, wobei der Treiberbaustein (9) zwischen der Ansteuerkomponente (8) und dem Eingang (2, 3) bzw. dem Ausgang (4, 5) angeordnet ist.

6. Schaltung nach einem der vorhergehenden Ansprüche,
**dadurch gekennzeichnet,**
**dass** der mindestens eine Eingang (2, 3) ein digitaler Eingang ist und der mindestens eine Ausgang (4, 5) ein digitaler Ausgang ist.

7. Schaltung nach einem der vorhergehenden Ansprüche,
**dadurch gekennzeichnet,**
**dass** jeweils mindestens zwei Eingänge (2, 3) und zwei Ausgänge (4, 5) vorgesehen sind.

8. Schaltung nach einem der vorhergehenden Ansprüche,
**dadurch gekennzeichnet,**
**dass** die Ansteuerkomponente (8) sicherheitsgerichtete Firmwarekomponenten (11, 12) aufweist.

9. System, insbesondere industrielles Automatisierungssystem, mit einer Schaltung (1) nach einem der vorhergehenden Ansprüche und mit mindestens einer sicherheitsgerichteten Komponente (14, 18), welche an mindestens einen Eingang (2, 3) und mindestens einen Ausgang (4, 5) der Schaltung (1) derart angeschlossen ist, dass der jeweilige Eingang (2, 3) mit dem jeweiligen Ausgang (4, 5) im sicheren Zustand elektrisch leitend verbunden ist.

10. Verfahren zum Testen einer elektronischen Schaltung (1), die mindestens einen Eingang (2, 3) und mindestens einen Ausgang (4, 5) aufweist, bei welchem Verfahren eine Änderung eines Eingangssignals durch ein Eingangsfilter (6, 7) des Eingangs (2, 3) verzögert wird, wobei die Verzögerung durch eine Zeitkonstante charakterisiert ist, wobei das Eingangssignal durch eine Ansteuerkomponente (8) bereitgestellt und ausgewertet wird, wobei das Ausgangssignal als Eingangssignal auf den Eingang rückgeführt wird,
**dadurch gekennzeichnet,**
**dass** ein durch die Ansteuerkomponente (8) bereitgestelltes Testsignal durch den Ausgang (4, 5) ausgegeben wird und das rückgeführte Testsignal als Eingangssignal unmittelbar nach Ausgabe des Testsignals zum ersten Mal und nach Ablauf einer Zeit nach Ausgabe des Testsignals, die mindestens der Zeitkonstanten entspricht, zum zweiten Mal ausgewertet wird.

11. Verfahren nach Anspruch 10,
**dadurch gekennzeichnet,**
**dass** das Eingangssignals innerhalb einer Zeit nach Ausgabe des Testsignals zum ersten Mal ausgewertet wird, die maximal 10 Prozent der Zeitkonstanten beträgt.

12. Verfahren nach Anspruch 10 oder 11,
**dadurch gekennzeichnet,**
**dass** jeweils das beim ersten und beim zweiten Mal ausgewertete Eingangssignal mit dem Testsignal verglichen wird.

13. Verfahren nach einem der Ansprüche 10 bis 12,
**dadurch gekennzeichnet,**
**dass** eine sicherheitsgerichtete Reaktion ausgelöst wird, sofern die erstmalige Auswertung ein Eingangssignal gleich dem Testsignal ergibt.

## Claims

1. Electronic circuit (1) with at least one input (2, 3) and at least one output (4, 5), with the input (2, 3) featuring an input filter (6, 7) for delaying a change to an input signal, with the delay being **characterised by** a time constant, with a control component being provided (8) for supply of an output signal and for evaluation of the input signal, with the output signal being provided for feedback to the input,
**characterised in that**
the control component (8) is provided to supply a test signal for output through the output (4, 5) and for a first evaluation of the input signal immediately after output of the test signal and for a second evaluation of the input signal after expiry of a time after output of the test signal which corresponds at least to the time constant.

2. Circuit in accordance with claim 1,
**characterised in that**
the control component (8) is provided for first evaluation of the input signal within a time after output of the test signal which amounts to a maximum of 10 percent of the time constant.

3. Circuit in accordance with claim 1 or 2,
**characterised in that**
the control component (8) is provided for comparison of the first and the second evaluation respectively with the test signal.

4. Circuit in accordance with one of the previous claims,
**characterised in that**
the control component (8) is provided for initiating a fail-safe reaction provided the first evaluation produces an input signal equal to the test signal.

5. Circuit in accordance with one of the previous claims,
**characterised in that**
at least one driver chip (9) is provided for conversion of the input and output signals, with the driver chip being arranged (9) between the control component (8) and the input (2, 3) or the output (4, 5).

6. Circuit in accordance with one of the previous claims,
**characterised in that**
the at least one input (2, 3) is a digital input and the at least one output (4, 5) is a digital output.

7. Circuit in accordance with one of the previous claims,
**characterised in that**
at least two inputs (2, 3) and two outputs (4, 5) are provided in each case.

8. Circuit in accordance with one of the previous claims,
**characterised in that**
the control component (8) features fail-safe firmware components (11, 12).

9. System, especially industrial automation system, with a circuit (1) in accordance with one of the previous claims, and with at least one fail-safe component (14, 18), which is connected to at least one input (2, 3) and at least one output (4, 5) of the circuit (1) in such as way that the relevant input (2, 3) is connected in an electrically conductive manner to the relevant output (4, 5) in the safe state.

10. Method for testing an electronic circuit (1), which features at least one input (2, 3) and at least one output (4, 5), in which method a change of an input signal is delayed by an input filter (6, 7) of the output (2, 3) with the delay being **characterised by** a time constant, with the input signal being supplied and evaluated by a control component (8),with the output signal being fed back to the input as an input signal,
**characterised in that**
a test signal provided by the control component (8) is output through the output (4, 5) and the fed back test signal as input signal is evaluated for the first time immediately after the output of the test signal and for the second time after expiry of a time after the output of the test signal which corresponds to at least the time constant.

11. Method in accordance with claim 10,
**characterised in that**
the input signal is evaluated for the first time within a time after output of the test signal which amounts to a maximum of 10 percent of the time constant.

12. Method in accordance with claim 10 or 11,
**characterised in that**
the input signal evaluated the first time and the second time respectively is compared to the test signal.

13. Method in accordance with one of the claims 10 to 12,
**characterised in that**
a fail-safe reaction is initiated provided the first evaluation produces an input signal equal to the test signal.

## Revendications

1. Circuit (1) électronique ayant au moins une entrée (2, 3) et au moins une sortie (4, 5), l'entrée (2, 3) ayant un filtre (6, 7) d'entrée pour la temporisation d'une modification d'un signal d'entrée, la temporisation étant **caractérisée par** une constante de temps, le circuit électronique ayant un composant (8) de commande pour la mise à disposition d'un signal de sortie et pour l'évaluation du signal d'entrée, le signal de sortie étant prévu pour retourner à l'entrée,
**caractérisé**
**en ce que** le composant (8) de commande est prévu pour la mise à disposition d'un signal de test à émettre par la sortie (4, 5) et d'une première évaluation du signal d'entrée juste après l'émission du signal de test et pour une deuxième évaluation du signal d'entrée après expiration d'une durée après l'émission du signal de test qui correspond au moins à la constante de temps.

2. Circuit suivant la revendication 1,
**caractérisé**
**en ce que** le composant (8) de commande est prévu pour la première évaluation du signal d'entrée dans un temps après l'émission du signal de test qui représente au maximum 10 pourcent de la constante de temps.

3. Circuit suivant la revendication 1 ou 2,
**caractérisé**
**en ce que** le composant (8) de commande est prévu pour comparer respectivement la première et la deuxième évaluation au signal de test.

4. Circuit suivant l'une des revendications précédentes,
**caractérisé**
**en ce que** le composant (8) de commande est prévu pour déclencher une réaction de sécurité dans la mesure où la première évaluation donne un signal d'entrée égal au signal de tête.

5. Circuit suivant l'une des revendications précédentes,
**caractérisé**
**en ce qu'**il est prévu au moins un module (9) d'attaque pour transformer les signaux d'entrée et de sortie, le module (9) d'attaque étant monté entre le composant (8) de commande et l'entrée (2, 3) ou la sortie (4, 5).

6. Circuit suivant l'une des revendications précédentes,
**caractérisé**
**en ce que** la au moins une entrée (2, 3) est une entrée numérique et la au moins une sortie (4, 5) est une sortie numérique.

7. Circuit suivant l'une des revendications précédentes,
**caractérisé**
**en ce qu'**il est prévu respectivement au moins deux entrées (2, 3) et deux sorties (4, 5).

8. Circuit suivant l'une des revendications précédentes,
**caractérisé**
**en ce que** le composant (8) de commande a des composants de microprogrammation de sécurité.

9. Système, notamment système d'automatisation industriel, comprenant un circuit (1) suivant l'une des revendications précédentes et au moins un composant (14, 18) de sécurité qui est relié au moins à une entrée (2, 3) et au moins à une sortie (4, 5) du circuit (1), de façon que l'entrée (2, 3) respective soit reliée d'une manière conductrice de l'électricité à l'état sûr à la sortie (4, 5) respective.

10. Procédé de test d'un circuit (1) électronique qui a au moins une entrée (2, 3) et au moins une sortie (4, 5), procédé dans lequel on retarde une modification d'un signal d'entrée par un filtre (6, 7) de l'entrée (2, 3), la temporisation s'étant **caractérisée par** une constante de temps, dans lequel le signal d'entrée est mis à disposition par un composant (8) de commande et est évalué, le signal de sortie étant retourné à l'entrée en tant que signal d'entrée,
**caractérisé**
**en ce qu'**un signal de test mis à disposition par le composant (8) de commande est émis par la sortie (4, 5) et le signal de test retourné est évalué en tant que signal d'entrée juste après l'émission du signal de test pour la première fois et après qu'une certaine durée s'est écoulée après l'émission du signal de test qui correspond au moins à la constante de temps pour la deuxième fois.

11. Procédé suivant la revendication 10,
**caractérisé**
**en ce que** le signal d'entrée est évalué pour la première fois à l'intérieur d'un temps après l'émission du signal de test qui représente au maximum 10 pourcent de la constante de temps.

12. Procédé suivant la revendication 10 ou 11,
**caractérisé**
**en ce que** le signal d'entrée, évalué pour la première fois et pour la deuxième fois, est comparé respectivement au signal de test.

13. Procédé suivant l'une des revendications 10 à 12,
**caractérisé**
**en ce qu'**une réaction de sécurité est déclenchée dans la mesure où l'évaluation pour la première fois donne un signal d'entrée égal au signal de test.
